# EUROPEAN PATENT SPECIFICATION

(11) **EP 3 041 032 B1**
(45) Date of publication and mention of the grant of the patent: **06.03.2019**
(21) Application number: 14853724.4
(22) Date of filing: 06.10.2014
(51) Int. Cl.: H01L 21/288, C01G 53/00, H01B 3/12, H01B 13/00, H01G 4/33, H01L 21/822, H01L 21/8246, H01L 27/04, H01L 27/105, H01L 41/047, H01L 41/29, H01L 41/319

(54) **LANIO3 THIN-FILM-FORMING COMPOSITION, AND METHOD FOR FORMING LANIO3 THIN-FILM IN WHICH SAID COMPOSITION IS USED**
LANIO3-DÜNNFILM-FORMUNGSZUSAMMENSETZUNG SOWIE VERFAHREN ZUR FORMUNG EINES LANIO3-DÜNNFILMS UNTER VERWENDUNG DIESER ZUSAMMENSETZUNG
COMPOSITION DE FORMATION DE FILM MINCE DE LANIO3, ET PROCÉDÉ DE FORMATION D'UN FILM MINCE DE LANIO3 DANS LEQUEL LADITE COMPOSITION EST UTILISÉE

(30) Priority: 15.10.2013 JP 2013214458; 01.10.2014 JP 2014202797
(43) Date of publication of application: 06.07.2016
(73) Proprietor: Mitsubishi Materials Corporation, Chiyoda-ku Tokyo 100-8117 (JP)
(72) Inventor: FUJII, Jun, Naka-shi Ibaraki 311-0102 (JP); SAKURAI, Hideaki, Naka-shi Ibaraki 311-0102 (JP); SOYAMA, Nobuyuki, Naka-shi Ibaraki 311-0102 (JP)
(74) Representative: Gille Hrabal
(86) International application number: PCT/JP2014/076646
(87) International publication number: WO 2015/056587

(56) References cited:
- EP-A2- 1 675 163
- WO-A1-2009/157189
- WO-A1-2012/074115
- CN-A- 1 362 749
- CN-A- 102 320 670
- CN-B- 102 515 763
- JP-A- 2009 010 367
- JP-A- 2009 215 109
- JP-A- 2010 013 325
- JP-A- 2013 110 177
- JP-B2- 3 079 262
- KR-A- 20120 052 799
- US-A1- 2005 211 135
- US-A1- 2007 172 592

## Description

### TECHNICAL FIELD

The present invention relates to a composition for forming an LaNiO₃ thin-film used in an electrode for a thin-film capacitor, a capacitor for a ferroelectric random access memory (FeRAM), a piezoelectric element or a pyroelectric infrared detecting device by chemical solution deposition (CSD) method, and a method for forming an LaNiO₃ thin-film in which said composition is used. More specifically, the present invention relates to an LaNiO₃ thin-film-forming composition capable of achieving uniform film formation to generate an extremely small number of pinholes, and a method for forming an LaNiO₃ thin-film in which said composition is used. This international application claims the priority of Japanese Patent Application No. 2013-214458 filed on October 15, 2013 and Japanese Patent Application No. 2014-202797 filed on October 1, 2014.

### BACKGROUND ART

A conventional type of LaNiO₃ thin-film is formed by vacuum deposition method such as sputtering coating, and by chemical solution deposition (CSD) method such as sol-gel process by applying a sol-gel solution (composition) obtained by dissolving an LaNiO₃ precursor in a solvent to form a coating film and firing the same at a predetermined temperature to be crystallized (see, e.g. Patent Document 1). In a method for producing a transparent conductive thin-film described in the Patent Document 1, an embrocation composed of an aqueous solution obtained by dissolving lanthanum salt, nickel salt and a water-soluble organic binder is prepared and the above embrocation is applied to a base material. Subsequently, a generated coating film is fired at a temperature of 500 to 800°C in oxygen atmosphere. Accordingly, a thin-film composed of metal oxide of a perovskite structure having an LaNiO₃ composition of a film thickness adjusted so that a volume resistivity is 2×10⁻⁵Ω• m or less at a temperature of 20 to 800°C, or a surface resistance is 300Ω/□ or less is obtained. The method for producing a transparent conductive thin-film configured in this way is used to efficiently manufacture a transparent conductive thin-film composed of LaNiO₃ of a perovskite structure.

Patent Document 2 discloses a LaNiO₃ thin film-forming composition comprising a LaNiO₃ precursor, an organic solvent and a stabilizer. The solvent is a diol. Preferred diols are 1,3-propanediol, 1,4-butanediol, 1,5-pentanediol and 1,6-hexanediol.

Patent Document 3 discloses a method for preparing a lanthanum nickelate conductive metal oxide film, wherein LaNO₃ and La acetate are dissolved in ethanol as a solvent.

Patent Document 4 discloses a similar method wherein acetic acid and deionized water are used as a solvent and methanamide is used as an additive.

Patent Document 5 discloses a sol gel process for forming a lanthanum nickelate metal oxide film using deionized water, glacial acetic acid and glycol methyl ether as a solvent.

Patent Document 6 relates to BiNbO₄ ferroelectric films. For forming the film an organic solvent is used, preferably an alcohol.

### PRIOR ART DOCUMENTS

### PATENT DOCUMENTS

Patent Document 1: Japanese Patent No. 3079262 (Claim 3, para [0011])
Patent Document 2: US 2005/211135 A
Patent Document 3: CN 102 320 670 A
Patent Document 4: CN 1 362 749 A
Patent Document 5: CN 102 515 763 A
Patent Document 6: EP 1 675 163 A

### SUMMARY OF THE INVENTION

### PROBLEM TO BE SOLVED BY THE INVENTION

Nevertheless, a method for forming an LaNiO₃ thin-film by CSD method such as sol-gel process has not unfortunately been firmly established, and distinctive film formation conditions such as the type of solvent contained in a composition and firing temperature can cause various disadvantages. A conventional method for producing a transparent conductive thin-film shown in the above Patent Document 1 has a problem that it fails to achieve uniform film formation due to many voids generated on a fired thin-film. This is primarily attributed to many pinholes generated on a coating film just after film formation, with a composition to be used containing a water-soluble component having high surface tension as a solvent. Void generation leads to non-uniform film thickness, resulting in such problems as increased film resistivity. In view of such circumstances, inventors of the present invention have found that when an LaNiO₃ thin-film is formed by a sol-gel process, the film has been improved particularly by selecting a material contained in a composition, and consequently pinholes generated on a coating film just after film formation can be reduced, thereby significantly suppressing voids generated on a fired thin-film to achieve uniform film formation. Based on that information, the present invention was accomplished.

It is an object of the present invention to provide an LaNiO₃ thin-film-forming composition capable of achieving uniform film formation to generate an extremely small number of pinholes, and a method for forming an LaNiO₃ thin-film in which said composition is used. It is another object of the present invention to provide an LaNiO₃ thin-film-forming composition capable of suppressing precipitation (deposition) of an LaNiO₃ precursor, and improving storage stability. It is another object of the present invention to provide an LaNiO₃ thin-film-forming composition capable of suppressing cracks generated on a fired LaNiO₃ thin-film, and a method for forming an LaNiO₃ thin-film in which said composition is used.

### MEANS FOR SOLVING THE PROBLEM

A first aspect of the present invention is an LaNiO₃ thin-film-forming composition, comprising an LaNiO₃ precursor, an organic solvent and a stabilizer, characterized in that the mixture ratio of the LaNiO₃ precursor relative to a total of 100% by mass of the LaNiO₃ precursor, the organic solvent, and the stabilizer is 1 to 20% by mass on an oxide basis, the mixture ratio of the stabilizer relative to ta total amount of the LaNiO₃ precursor (1 mol2) is over 0 moles and 10 moles or less, and the remainder is the organic solvent,
the organic solvent is one type of single solvent selected from the group consisting of ethylene glycol monopropyl ether, ethylene glycol monoisopropyl ether, 3-methoxy-1-butanol, hexamethylene tetramine, isoamyl acetate, glycerol 1,2-carbonate, diethyl carbonate, and lactic acid or a mixed solvent composed of ethylene glycol monoisopropylether and ethanol, and
the dispersion component dD, the polarization component dP, and the hydrogen bond component dH of the HSP value of the organic solvent fulfill the relations 14<dD<20, 3<dP<26, and 3<dH<30, respectively.

A second aspect of the present invention is the invention according to the first aspect, wherein the LaNiO₃ precursor is metal carboxylate, metal nitrate, metal alkoxide, a metal diol complex, a metal triol complex, a metal β-diketonate complex, a metal β-diketoester complex, a metal β-iminoketo complex, or a metal amino complex.

A third aspect of the present invention is the invention according to the second aspect, wherein at least one of an LaNiO₃ precursor as an La source and an LaNiO₃ precursor as a Ni source is acetate.

A fourth aspect of the present invention is the invention according to the second aspect, wherein at least one of an LaNiO₃ precursor as an La source and an LaNO₃ precursor as a Ni source is nitrate.

A fifth aspect of the present invention is a method for forming an LaNiO₃ thin-film in which the LaNiO₃ thin-film-forming composition according to any one of the first to fourth aspects is used.

A sixth aspect of the present invention is a method for forming an LaNiO₃ thin-film, comprising the steps of:
forming a coating film by applying the LaNiO₃ thin-film-forming composition according to any one of the first to fourth aspects to a heat-resistant substrate; and
after calcining the substrate having the coating film at atmospheric pressure in oxidizing atmosphere or in water vapor-containing atmosphere or after repeatedly forming and calcining the coating film twice or more until the thickness comes to a desired value, and then forming an LaNiO₃ thin-film preferentially oriented to a (100) plane on the substrate by firing the coating film at a crystallization temperature or more.

A seventh aspect of the present invention is an electronic component including an LaNiO₃ thin-film formed by the method according to the fifth or sixth aspect.

### EFFECT OF THE INVENTION

The LaNiO₃ thin-film-forming composition according to the first aspect of the present invention as defined in claim 1 uses no water-soluble component as a solvent unlike conventional one, and can significantly reduce pinholes generated on a coating film just after film formation by containing an LaNiO₃ precursor and an organic solvent, and fulfilling the above relations of the dispersion component dD, the polarization component dP, and the hydrogen bond component dH of the HSP value of the organic solvent. Additionally, by containing a stabilizer in a composition with the above ratio, storage stability can be improved. Also, containing an LaNiO₃ precursor with a predetermined ratio, cracks generated on a fired LaNiO₃ thin- film can be suppressed, and precipitation (deposition) of an LaNiO₃ precursor can be suppressed.

The LaNiO₃ thin-film-forming composition according to the second aspect of the present invention can further improve the compositional uniformity of the composition because the LaNiO₃ precursor is metal carboxylate or the like.

The LaNiO₃ thin-film-forming composition according to the third or fourth aspect of the present invention can further improve the storage stability by using acetate or nitrate as an LaNiO₃ precursor, even if a composition of relatively high concentration is prepared.

The LaNiO₃ thin-film-forming composition according to the first aspect of the present invention can improve the coating film property because the organic solvent is one type of single solvent selected from the group consisting of ethylene glycol monopropyl ether, ethylene glycol monoisopropyl ether, 3-methoxy-1-butanol, hexamethylene tetramine, isoamyl acetate, glycerol 1, 2-carbonate, diethyl carbonate, and lactic acid, or a mixed solvent composed of ethylene glycol monoisopropylether and ethanol.

The method for forming an LaNiO₃ thin-film according to the fifth aspect of the present invention can form an LaNiO₃ thin-film of uniform thickness having few voids generated after firing derived from an extremely small number of pinholes generated on a coating film just after film formation by forming an LaNiO₃ thin-film by using the above LaNiO₃ thin-film-forming composition.

The method for forming an LaNiO₃ thin-film according to the sixth aspect of the present invention can form an uniform LaNiO₃ thin-film preferentially oriented to a (100) plane having few voids generated after firing derived from an extremely small number of pinholes generated on a coating film just after film formation by forming a coating film by applying an LaNiO₃ thin-film-forming composition to a heat-resistant substrate, repeatedly forming and calcining the coating film twice or more after calcining the substrate having the coating film at atmospheric pressure in oxidizing atmosphere or in water vapor-containing atmosphere or until the thickness comes to a desired value, and firing the coating film at a crystallization temperature or more.

The electronic component including the LaNiO₃ thin-film according to the seventh aspect of the present invention can obtain a device excellent in fatigue property by using a uniform thin- film formed by the above method having few voids generated in a capacitor electrode of a ferroelectric memory or a piezoelectric electrode when the ferroelectric memory or a piezoelectric element is manufactured. Also, since the film obtained by the forming method according to the present invention is translucent, the film can be used as an electrode film of a pyroelectric infrared detecting device as well. Furthermore, since the LaNiO₃ thin-film has self-orientation on a (100) plane, the film can be used as a crystal orientation control layer for controlling crystal orientation of a dielectric layer, particularly when a thin-film capacitor or a piezoelectric element is manufactured.

### BRIEF DESCRIPTION OF THE DRAWINGS

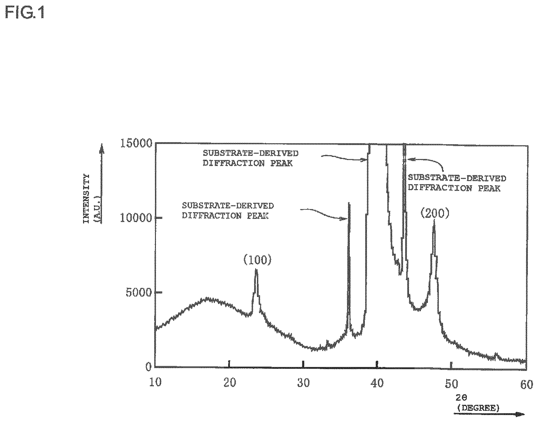

Fig. 1 is a diagram showing an XRD pattern of an LaNiO₃ thin-film formed in Example 1.

### DESCRIPTION OF THE PREFERRED EMBODIMENTS

Next, an embodiment of the present invention will be described.

The composition of the present invention includes an LaNiO₃ precursor, an organic solvent, and a stabilizer. Also, the mixture ratio of the LaNiO₃ precursor relative to a total of 100% by mass of the LaNiO₃ precursor, the organic solvent, and the stabilizer is 1 to 20% by mass on an oxide basis, preferably 3 to 15% by mass. The mixture ratio of the stabilizer relative to a total amount of the LaNiO₃ precursor (1 mole) is over 0 mole and 10 moles or less, and more preferably 2 to 8 moles. Further, the dispersion component dD, the polarization component dP, and the hydrogen bond component dH of the HSP value of the organic solvent fulfill the following relations, respectively: 14<dD<20, preferably 15<dD<17; 3<dP<26, preferably 5<dP<9; and 3<dH<30, preferably 13<dH<22. The dispersion component dD, the polarization component dP, and the hydrogen bond component dH of the HSP value of the organic solvent can be determined by the values of the evaporation heat, the molecular volume, the refractive index, and the dipole moment. Specifically, d_{Tot} can be determined by the evaporation heat, dP by the dipole moment and the molecular volume, dD by the refractive index, and dH by the above d_{Tot}, dP, and dD. Here, d_{Tot} is the sum of dD, dP, and dH.

The above LaNiO₃ precursor is a raw material for composing composite metal oxide (LaNiO₃) in a formed LaNiO₃ thin-film, including metal carboxylate, metal nitrate, metal alkoxide, a metal diol complex, a metal triol complex, a metal β-diketonate complex, a metal β-diketoester complex, a metal β-iminoketo complex or a metal amino complex of each metal element of La or Ni. Illustrative example of the LaNiO₃ precursor as an La source includes: metal carboxylate such as lanthanum acetate, octyl acid lanthanum, and lanthanum 2-ethylhexanoate; metal nitrate such as lanthanum nitrate; metal alkoxide such as lanthanum isopropoxide; and a metal β-diketonate complex such as lanthanum acetyl acetonate. Illustrative example of the LaNiO₃ precursor as a Ni source includes: metal carboxylate such as nickel acetate, octyl acid nickel, and nickel 2-ethylhexoate; metal nitrate such as nickel nitrate; and a metal β-diketonate complex such as nickel acetylacetonate. In view of high degree of dissolution in a solvent and storage stability in particular, at least one of an LaNiO₃ precursor as an La source and an LaNiO₃ precursor as an Ni source is preferably acetate or nitrate. The LaNiO₃ precursor is preferably dehydrated by heating means or other means in advance, or dehydrated by distilling means or other means during synthesis of the precursor in view of suppressing pinholes generated on a coating film. If the La source or the Ni source is a hydrate, the LaNiO₃ precursor is essentially dehydrated.

The mixture ratio of the LaNiO₃ precursor (a total of an La source and a Ni source) relative to a total of 100% by mass of the LaNiO₃ precursor, the organic solvent, and the stabilizer is limited to a range of 1 to 20% by mass on an oxide basis. This is because if the ratio of the LaNiO₃ precursor is under 1% by mass, the thickness of a coated film is too small, resulting in such problems as cracks on a fired LaNiO₃ thin-film, and if the ratio exceeds 20% by mass, degradation of the storage stability such as precipitation (deposition) of an LaNiO₃ precursor is generated. The ratio on an oxide basis corresponds to the ratio of the metal oxide relative to a total of 100% by mass of the LaNiO₃ precursor, the organic solvent, and the stabilizer if all the metal elements contained in a composition turn into oxide. The mixture ratio of an LaNiO₃ precursor as an La source and an LaNiO₃ precursor as a Ni source is preferably determined so that the metal atomic ratio (La/Ni) of an La element and a Ni element is 1:1.

The organic solvent for use includes one type of single solvent selected from the group consisting of ethylene glycol monopropyl ether, ethylene glycol monoisopropyl ether, 3-methoxy-1-butanol, hexamethylene tetramine, isoamyl acetate, glycerol 1,2-carbonate, diethyl carbonate, and lactic acid, or a mixed solvent composed of ethylene glycol monoisopropylether and ethanol.

In addition, the HSP value of the organic solvent is Hansen solubility parameter, which refers to the index of how much one substance is dissolved in another substance. The Hansen solubility parameter refers to the solubility in the form of three-dimensional vectors (dispersion component dD, polarization component dP, and hydrogen bond component dH). The more approximate the vectors are, the higher solubility is judged. The above dispersion component dD is Van der Waals' forces, the polarization component dP is force of dipole moment, and the hydrogen bond component dH is force found in water or alcohol. Herein, the dispersion component dD, the polarization component dP, and the hydrogen bond component dH of the HSP value of the organic solvent are limited to the ranges of 14<dD<20, 3<dP<26, and 3<dH<30, respectively. This is because their deviation from each range leads to degraded solubility in the organic solvent of the LaNiO₃ precursor, precipitation of the LaNiO₃ precursor, pinholes generated on a coating film applied to a substrate, or degradation of a coating film property on a substrate of a composition to generate cracks on a fired thin-film. Specifically, the dispersion component dD of the HSP value of the organic solvent is limited to the range of 14<dD<20, because if the dD is 14 or less or 20 or more, the LaNiO₃ precursor can precipitate. The polarization component dP of the HSP value of the organic solvent is limited to the range of 3<dP<26, because if the dP is 3 or less, the LaNiO₃ precursor can precipitate, and if the dP is 26 or more, pinholes are generated on a coating film of the LaNiO₃ thin-film-forming composition applied to a substrate. Further, the hydrogen bond component dH of the HSP value of the organic solvent is limited to the range of 3<dH<30, because if the dH is 3 or less, the LaNiO₃ precursor can precipitate, and if the dH is 30 or more, pinholes are generated on a coating film of the LaNiO₃ thin-film-forming composition applied to a substrate.

Meanwhile, illustrative preferable example of the stabilizer for use includes one or more types of those selected from the group consisting of β-diketone (e.g. acetylacetone, heptafluorobutyrylpivaloylmethane, dipivaloyl methane, trifluoroacetylacetone, and benzoylacetone), β-ketonic acid (e.g. acetoacetic acid, propionyl acetic acid, and benzoyl acetic acid), β-keto ester (e.g. lower alkylester of methyl, propyl, and butyl of the above ketonic acid), oxyacid (e.g. lactic acid, glycolic acid, α-oxybutyric acid, and salicylic acid), diol, triol, carboxylic acid, alkanolamine (e.g. diethanolamine, triethanolamine, monoethanolamine, and N-methylformamide), and polyvalent amine. The storage stability of a composition can be improved by adding these stabilizers. Among them, in particular, alkanolamine such as N-methylformamide and diethanolamine is preferable due to high effect of improving the storage stability. The mixture ratio of the stabilizer relative to a total amount of the LaNiO₃ precursor (1 mole) is limited to the range of over 0 mole and 10 moles or less, because there occurs a problem that the ratio of the stabilizer exceeding an upper limit leads to slower thermal decomposition of the stabilizer and cracks generated on a thin-film. Among them, the ratio of the stabilizer relative to a total amount of the above LaNiO₃ precursor (1 mole) is preferably 2 to 8 moles. Illustrative preferable example of the carboxylic acid as a stabilizer includes acetic acid, octylic acid, and 2-ethyl hexanoic acid. If carboxylic acid is used as a stabilizer, the upper limit of the ratio of the above-described stabilizer shows the ratio of carboxylic acid as the stabilizer.

To obtain the LaNiO₃ thin-film-forming composition according to the present invention, the above-described LaNiO₃ precursor as an La source and the above-described LaNiO₃ precursor as a Ni source are each prepared, and these are weighed so that the above desired metal atomic ratio can be given. Additionally, the above stabilizer is prepared, and weighed so that the mixture ratio is the above-described predetermined ratio relative to 1 mole of the above LaNiO₃ precursor (a total amount of an LaNiO₃ precursor as an La source and an LaNiO₃ precursor as a Ni source) . Next, an LaNiO₃ precursor as a Ni source, the above-described organic solvent, and the above stabilizer are fed into in a reaction vessel and mixed. If the Ni source is a hydrate, it is distilled for dehydration. An LaNiO₃ precursor as an La source is added thereto, and heated and reacted at a temperature of 80 to 200°C for 10 minutes to 2 hours, preferably in atmosphere of inert gas such as nitrogen gas and argon gas to prepare a synthetic liquid (mixed solution). If the La source is a hydrate, it is distilled for dehydration. Thereafter, the above-described organic solvent is further added thereto, and diluted so that the above precursor concentration is in the above-described desired range (weight is adjusted) and agitated to obtain a composition. After preparation, to suppress a temporal change in the composition, the product is preferably heated at a temperature of 80 to 200°C for 10 minutes to 2 hours, preferably in atmosphere of inert gas such as nitrogen gas and argon gas. Also, after an LaNiO₃ precursor as a Ni source, an LaNiO₃ precursor as an La source, and an organic solvent are fed into a reaction vessel and mixed and distilled for dehydration, a stabilizer is added thereto, and heated and reacted at a temperature of 80 to 200°C for 10 minutes to 2 hours in inert gas atmosphere to prepare a synthetic liquid (mixed solution), and an organic solvent may further be added thereto for weight adjustment to obtain a composition.

In the present invention, particles are preferably removed from the above prepared composition by filtration to make the number of particles with a particle diameter of 0.5µm or more (0.3µm or more, and particularly 0.2µm or more) 50/ml or less per 1 ml of solution. The number of particles in a composition is measured by light scattering automatic particle counter.

If the number of particles with a particle diameter of 0.5µm or more in a composition exceeds 50/ml, the long-term storage stability is degraded. A smaller number of particles with a particle diameter of 0.5µm or more in the composition is preferable, particularly 30/ml or less.

To achieve the above number of particles, a method for treating a prepared composition is not particularly limited, but illustrative example thereof includes the following method. A first method is a filtration method for force-feeding the composition by a syringe using a commercially available membrane-filter with a pore diameter of 0.2µm. A second method is a pressure filtration method using a commercially available membrane-filter with a pore diameter of 0.05µm and a pressure tank combined. A third method is a recirculation filtration method using the filter used in the above second method and a solution circulation tank combined.

The particle trapping efficiency by a filter varies depending on the solution force-feeding pressure in each method. It is commonly known that lower pressure leads to a higher trapping efficiency. In particular, to make the number of particles with a particle diameter of 0.5µm or more 50 or less in the first and second methods, a solution preferably passes through a filter extremely slowly at low pressure.

Subsequently, the method for forming an LaNiO₃ thin-film according to the present invention will be described. First, the above LaNiO₃ thin-film-forming composition is applied to a substrate to form a coating film with a desired thickness. The coating method is not particularly limited, but spin-coating, dip-coating, liquid source misted chemical deposition (LSMCD) method or electrostatic spray method is preferable. A substrate on which an LaNiO₃ thin-film is formed varies depending on the use, but if it is used as a crystal orientation control layer such as a thin-film capacitor, a heat-resistant substrate such as a silicon substrate on which a lower electrode is formed and a sapphire substrate are used. Illustrative example of the lower electrode formed on a substrate includes a material such as Pt, Ir, and Ru having electrical conductivity which does not react with an LaNiO₃ thin-film. A substrate on which a lower electrode is formed via an adhesion layer and an insulator film can be used. Specifically, a substrate obtained by laminating an SiO₂ layer, a Ti layer and a Pt layer (top layer) in series on an Si base material, and a substrate obtained by laminating an SiO₂ layer, a TiO₂ layer and a Pt layer (top layer) in series on an Si base material are preferable. Also, a substrate obtained by laminating an SiO₂ layer, an Ir layer, an IrO layer, and a Pt layer (top layer) in series on an Si base material, and a substrate obtained by laminating an SiO₂ layer, a TiN layer, and a Pt layer (top layer) on an Si base material are preferable. Further, a substrate obtained by laminating an SiO₂ layer, a Ta layer, and a Pt layer (top layer) in series on an Si base material, and a substrate obtained by laminating an SiO₂ layer, an Ir layer, and a Pt layer (top layer) on an Si base material are preferable. However, the substrate is not limited to the above substrate so long as it is a substrate obtained by laminating an insulator layer, an adhesion layer, and a lower electrode in series on a base material. Meanwhile, if the substrate is used in an electrode such as for a capacitor for a ferroelectric memory, a piezoelectric element, a pyroelectric infrared detecting device, and a heat-resistant substrate such as a silicon substrate, a substrate obtained by laminating an Si base material with SiO₂, and a sapphire substrate can be used.

After forming a coating film on a substrate, the coating film is calcined and then fired to be crystallized. The coating film is calcined under predetermined conditions using a hot plate or a rapid thermal annealing (RTA) device or the like. The coating film is calcined for removing a solvent therefrom and subjecting a metal compound to thermal decomposition or hydrolysis to turn it into complex oxide in the air, therefore it is preferable to carry out it in oxidizing atmosphere, or in water vapor-containing atmosphere. Even in heating in the air, the moisture required for hydrolysis is fully provided by humidity in the air. In order to remove in particular a low-boiling point component or adsorbed water molecule prior to calcination, the coating film may be heated at a low temperature of 60 to 120°C for 1 to 5 minutes using a hot plate. The coating film is preferably calcined at a temperature of 150 to 550°C for 1 to 10 minutes. The step of applying and calcining a composition is performed once and then the composition is fired if applying once enables to obtain a desired film thickness. Or, the step of applying and calcining a composition can repeatedly be performed and the composition may be fired finally so as to obtain a desired film thickness.

The firing step is to fire a calcined coating film at a temperature of a crystallization temperature or more to be crystallized to obtain an LaNiO₃ thin-film. The firing atmosphere in the step of crystallizing preferably includes O₂, N₂, Ar, N₂O, H₂ or a mixed gas thereof or the like. The coating film is fired by retaining the temperature, preferably at 450 to 900°C for 1 to 60 minutes. The coating film may be fired by rapid thermal annealing (RTA) method. The heating rate from room temperature to the above firing temperature is preferably 10 to 100°C/sec.

An LaNiO₃ thin-film is obtained by the above steps. The LaNiO₃ thin-film thus formed can be used in an electronic component such as a thin-film capacitor, a capacitor, an IPD, a capacitor for a DRAM memory, a laminated capacitor, a capacitor for a ferroelectric memory, a pyroelectric infrared detecting device, a piezoelectric element, an electro-optic device, an actuator, a resonator, an ultrasonic motor, an electric switch, an optical switch or an LC noise filter device. Specifically, the LaNiO₃ thin-film is low in surface resistivity and excellent in electrical conductivity. Since the film is also translucent, it can be used in an electrode film of a capacitor for a ferroelectric memory, an electrode film of a piezoelectric element, and an electrode film of a pyroelectric infrared detecting device. With self-orientation on a (100) plane, the LaNiO₃ thin-film can preferably be used as a crystal orientation control layer for subjecting crystal orientation of a dielectric layer in a thin-film capacitor to preferential orientation to a (100) plane. In particular, piezoelectric property can be improved in case of a piezoelectric element.

### EXAMPLE

Next, Examples of the present invention will be described in details along with Comparative Examples.

### <Example 1>

First, nickel (II) acetate tetrahydrate (Ni source) and lanthanum (III) nitrate hexahydrate (La source) were prepared as an LaNiO₃ precursor, and weighed so that the metal atomic ratio of La and Ni was 1:1. As a stabilizer, 5 mole of N-methylformamide relative to a total of the above precursor (1 mole) was prepared. Subsequently, the above nickel (II) acetate tetrahydrate (Ni source) and the above lanthanum (III) nitrate hexahydrate (La source) were placed in a reaction vessel, and ethylene glycol monopropyl ether was added thereto to prepare a synthetic liquid (mixed solution). Here, the dispersion component dD, the polarization component dP, and the hydrogen bond component dH of the HSP value of the above ethylene glycol monopropyl ether were expressed by dD=16.1, dP=8.7; and dH=13.5, respectively. Subsequently, the above synthetic liquid (mixed solution) was dehydrated by distillation and then N-methylformamide was added thereto as a stabilizer. Further, the mixed solution was heated and reacted at a temperature of 150°C for 20 minutes in argon gas (inert gas) atmosphere to prepare a synthetic liquid (mixed solution), and its weight was adjusted by ethylene glycol monopropyl ether. Accordingly, a composition was obtained so that the metal atomic ratio of La and Ni was 1:1 and the concentration of the LaNiO₃ precursor was 4% by mass on an oxide basis.

The above composition was applied on a substrate by spin-coating. Specifically, the above composition was dropped onto a Pt layer of a square substrate (17mm x 17mm) placed on a spin-coater, and a coating film was formed on the Pt layer of the substrate by spin-coating at a rotational velocity of 3000rpm for 15 seconds. The above substrate was a heat-resistant laminated substrate obtained by depositing an SiO₂ layer, a TiO₂ layer and a Pt layer in series on an Si base material, and a crystalline orientation surface of the Si base material was a (100) plane. Subsequently, prior to calcination and firing of the coating film on the above substrate, the substrate having the coating film formed was placed on a hot plate and retained at a temperature of 75°C for one minute in the atmosphere to remove a low-boiling component and an adsorbed water molecule (drying) . Next, the coating film on the above substrate was retained on the hot plate at a temperature of 450°C for 5 minutes to calcine the same. Further, the calcined coating film was heated up to 800°C at a heating rate of 10°C/sec in oxygen atmosphere by rapid thermal annealing (RTA) method, and fired while being kept at the temperature for 5 minutes to form an LaNiO₃ thin-film on the substrate.

### <Examples 2 to 13 and Comparative Examples 1 to 8>

As shown in Table 1, the compositions of Examples 2 to 13 and Comparative Examples 1 to 8 were each blended. The compositions to be blended, other than those shown in Table 1, were prepared as in Example 1, and each composition was applied to each substrate to form a coating film. An LaNiO₃ thin-film was produced by firing the coating film. As to the type of organic solvent in Table 1, "A" denotes ethylene glycol monopropyl ether, "B" denotes ethylene glycol monoisopropyl ether, "C" denotes 3-methoxy-1-butanol, "D" denotes ethanol, and "E" denotes acetic acid. "F" denotes hexamethylene tetramine, "G" denotes isoamyl acetate, "H" denotes glycerol 1,2-carbonate, "I" denotes diethyl carbonate, and "J" denotes lactic acid. "K" denotes methyl ethyl ether, "L" denotes propylene carbonate, "M" denotes formamide, "N" denotes dibutylamine, and "P" denotes dipentyl ether.

### <Comparative test 1 and evaluation>

Each preferential orientation surface of the LaNiO₃ thin-films of Examples 1 to 13 was determined by XRD pattern. Specifically, each LaNiO₃ thin-film was subjected to XRD analysis by concentration technique using X-ray diffraction (XRD) device (Product from PANalytical B.V., Name of Type: Empyrean). The results (only in Example 1) were shown in Fig. 1. As shown in Fig. 1, the preferential orientation surface of the LaNiO₃ thin-film of Example 1 was a (100) plane. In Fig. 1, 2θ was in the range of 20 to 40 degrees, and an orientation surface having a highest intensity excluding a diffraction peak derived from a substrate was defined as a preferential orientation surface. The result of XRD analysis which was carried out in each LaNiO₃ thin-film of Examples 2 to 13 in the same manner as described above showed that each preferential orientation surface was a (100) plane.

### <Comparative test 2 and evaluation>

First, whether deposit was formed on each composition of Examples 1 to 13 and Comparative Examples 1 to 8 or not was examined. Each deposit contained an LaNiO₃ precursor precipitated during heating and reacting in argon gas (inert gas) atmosphere of a composite (mixed solution), and an LaNiO₃ precursor precipitated after cooling which was carried out after the heating and reacting. Next, each composition of Examples 1 to 12 and Comparative Examples 1 to 9 was applied to a square substrate (17mm x 17mm) by spin-coating to visually examine whether the coating film just after applying includes a pinhole or not. Specifically, just after each composition was applied to a square substrate (17mm x 17mm), the number of pinholes with a diameter of 0.1mm or more was a factor in judgement. Generation of one or more pinholes was determined as "(pinhole was) found" and generation of no pinhole was determined as "None (of pinhole)." Further, whether cracks were generated on each fired LaNiO₃ thin-film of Examples 1 to 13 and Comparative Examples 1 to 8 was examined. Specifically, according to observation of a surface of each LaNiO₃ thin-film by a 10-time optical microscope, generation of a crack was determined as "(crack was) found," and generation of no crack was determined as "None (of crack)." Surfaces with deposition were not subjected to coating film evaluation. The results are shown in Table 1.

**[Table 1] (* not according to the invention)**

| | Composition | | | | | Composition | Coating film | Fired thin-film |
|---|---|---|---|---|---|---|---|---|
| | Precursor | Organic solvent | | | | Deposition | Pinhole | Crack |
| | Content (% by mass) | Type | HSP value | | | | | |
| | | | dD | dP | dH | | | |
| Example 1 | 4 | A | 16.1 | 8.7 | 13.5 | None | None | None |
| Example 2 | 4 | B | 16.0 | 8.2 | 13.1 | None | None | None |
| Example 3 | 4 | C | 15.3 | 5.4 | 13.6 | None | None | None |
| Example 4 | 4 | B+D | 15.9 | 8.6 | 17.5 | None | None | None |
| Example 5 | 1 | B+D | 15.9 | 8.6 | 17.5 | None | None | None |
| Example 6 | 20 | B+D | 15.9 | 8.6 | 17.5 | None | None | None |
| Example 7* | 4 | D | 15.8 | 8.8 | 19.4 | None | None | None |
| Example 8* | 4 | E | 14.5 | 8.0 | 13.5 | None | None | None |
| Example 9 | 4 | F | 19.4 | 7.0 | 16.0 | None | None | None |
| Example 10 | 4 | G | 15.3 | 3.1 | 7.0 | None | None | None |
| Example 11 | 4 | H | 17.9 | 25.5 | 17.4 | None | None | None |
| Example 12 | 4 | I | 15.1 | 6.3 | 3.5 | None | None | None |
| Example 13 | 4 | J | 17.0 | 8.3 | 28.4 | None | None | None |
| Comparative Example 1 | 4 | Water | 15.5 | 16.0 | 42.3 | None | Found | Found |
| Comparative Example 2 | 0.8 | B+D | 15.9 | 8.6 | 17.5 | None | Found | Found |
| Comparative Example 3 | 22 | B+D | 15.9 | 8.6 | 17.5 | Found | - | - |
| Comparative Example 4 | 4 | K | 14.0 | 4.7 | 6.0 | Found | - | - |
| Comparative Example 5 | 4 | L | 20.0 | 18.0 | 4.1 | Found | - | - |
| Comparative Example 6 | 4 | M | 17.2 | 26.2 | 19.0 | None | Found | Found |
| Comparative Example 7 | 4 | N | 15.0 | 3.0 | 4.3 | Found | - | - |
| Comparative Example 8 | 4 | P | 15.6 | 3.1 | 3.0 | Found | - | - |

As is evident from Table 1, in Comparative Example 2, in which the content of an LaNiO₃ precursor is less than 1% by mass, pinholes was generated on a coating film, and the thickness of the coating film was non-uniform. In Comparative Example 3, in which the content of an LaNiO₃ precursor exceeded 20% by mass, deposition was generated in the composition. In Comparative Example 4, in which dD of the HSP value of the organic solvent was small, deposition was generated in the composition, and in Comparative Example 5, in which dD of the HSP value of the organic solvent was large, deposition was generated in the composition. In Comparative Example 6, in which dP of the HSP value of the organic solvent was large, pinholes were generated on a coating film, and the thickness of the coating film was non-uniform. In Comparative Example 7, in which dP of the HSP value of the organic solvent was small, deposition was generated in the composition. Further, in Comparative Example 1, in which dH of the HSP value of the organic solvent was large, pinholes were generated on a coating film, and the thickness of the coating film was non-uniform. In Comparative Example 8, in which dH of the HSP value of the organic solvent was small, deposition was generated in the composition. In contrast, in Examples 1 to 13 (Examples 7 and 8 not according to the invention), in which dD, dP and dH of the HSP value of the solvent were appropriate, no pinhole was generated in the coating film, and the thickness of each coating film was uniform. Thus, in Examples 1 to 13 (Examples 7 and 8 not according to the invention) no crack was generated on each fired LaNiO₃ thin-film.

Specifically, in Comparative Example 2, in which the content of the LaNiO₃ precursor was small at 0.8% by mass, no deposition was generated in the composition, but pinholes were generated on the coating film, and the thickness of the coating film was non-uniform. In Comparative Example 3, in which the content of the LaNiO₃ precursor was large at 22% by mass, deposition was generated in the composition. In contrast, in Examples 5 and 6, in which the contents of the LaNiO₃ precursors were appropriate at 1% by mass and 20% by mass, respectively, nc deposition was generated in each composition, and each coating film generated no pinhole, and the thickness of the coating film was uniform.

In Comparative Example 4, in which dD of the HSP value of the organic solvent was small at 14.0, deposition was generated in the composition, and in Comparative Example 5, in which dD of the HSP value of the organic solvent was large at 20.0, deposition was generated in the composition. In contrast, in Comparative Examples 8 and 9, in which dD of the HSP values of the organic solvent were appropriate at 14.5 and 19.4, respectively, no deposition was generated in each composition, and each coating film generated no pinhole, and the thickness of the coating film was uniform.

In Comparative Example 7, in which dP of the HSP value of the organic solvent was small at 3.0, deposition was generated in the composition, and in Comparative Example 6, in which dP of the HSP value of the organic solvent was large at 26.2, no deposition was generated in the composition, but pinholes were generated on each coating film, and the thickness of the coating film was non-uniform. In contrast, in Comparative Examples 10 and 11, in which dP of the HSP values of the organic solvent were appropriate at 3.1 and 25.5, respectively, no deposition was generated in each composition, and each coating film generated no pinhole, and the thickness of the coating film was uniform.

Further, in Comparative Example 8, in which dH of the HSP value of the organic solvent was small at 3.0, deposition was generated in the composition, and in Comparative Example 1, in which dH of the HSP value of the organic solvent was large at 42.3, no deposition was generated in the composition, but pinholes were generated on each coating film, and the thickness of the coating film was non-uniform. In contrast, in Example 12 and 13, in which dH of the HSP values of the solvent were appropriate at 3.5 and 28.4, respectively, no deposition were generated in each composition, each coating film generated no pinhole, and the thickness of the coating film was uniform.

### INDUSTRIAL APPLICABILITY

The LaNiO₃ thin-film-forming composition according to the present invention can be used for manufacturing an electronic component such as a thin-film capacitor, a capacitor, an IPD , a capacitor for a DRAM memory, a laminated capacitor, a capacitor for a ferroelectric memory, a pyroelectric infrared detecting device, a piezoelectric element, an electro-optic element, an actuator, a resonator, an ultrasonic motor, an electric switch, an optical switch or LC noise filter device.

## Claims

1. An LaNiO₃ thin-film-forming composition, comprising an LaNiO₃ precursor, an organic solvent and a stabilizer, wherein the mixture ratio of the LaNiO₃ precursor relative to a total of 100% by mass of the LaNiO₃ precursor, the organic solvent, and the stabilizer is 1 to 20% by mass on an oxide basis, the mixture ratio of the stabilizer relative to a total amount of the LaNiO₃ precursor (1 mole) is over 0 mole and 10 moles or less, and the remainder is the organic solvent,
**characterized in that**,
the organic solvent is one type of single solvent selected from the group consisting of ethylene glycol monopropyl ether, ethylene glycol monoisopropyl ether, 3-methoxy-1-butanol, hexamethylene tetramine, isoamyl acetate, glycerol 1,2-carbonate, diethyl carbonate, and lactic acid or a mixed solvent composed of ethylene glycol monoisopropylether and ethanol, and
the dispersion component dD, the polarization component dP, and the hydrogen bond component dH of the HSP value of the organic solvent fulfill the relations 14<dD<20, 3<dP<26, and 3<dH<30, respectively.

2. The LaNiO₃ thin-film-forming composition according to claim 1, wherein the LaNiO₃ precursor is metal carboxylate, metal nitrate, metal alkoxide, a metal diol complex, a metal triol complex, a metal β-diketonate complex, a metal β-diketoester complex, a metal β-iminoketo complex, or a metal amino complex.

3. The LaNiO₃ thin-film-forming composition according to claim 2, wherein at least one of an LaNiO₃ precursor as an La source and an LaNiO₃ precursor as a Ni source among the LaNiO₃ precursors is acetate.

4. The LaNiO₃ thin-film-forming composition according to claim 2, wherein at least one of an LaNiO₃ precursor as an La source and an LaNO₃ precursor as a Ni source among the LaNiO₃ precursors is nitrate.

5. A method for forming an LaNiO₃ thin-film in which the LaNiO₃ thin-film-forming composition according to any one of claims 1 to 4 is used.

6. A method for forming an LaNiO₃ thin-film according to claim 5, comprising the steps of:
forming a coating film by applying the LaNiO₃ thin-film-forming composition according to any one of claims 1 to 4 to a heat-resistant substrate; and
after calcining the substrate having the coating film at atmospheric pressure in oxidizing atmosphere or in water vapor-containing atmosphere or repeatedly forming and calcining the coating film twice or more until the thickness comes to a desired value, and forming an LaNiO₃ thin-film preferentially oriented to a (100) plane on the substrate by firing the coating film at a crystallization temperature or more.

7. An electronic component including a LaNiO₃ thin-film formed by the method according to claim 5 or 6.

## Patentansprüche

1. LaNiO₃-Dünnschicht bildende Zusammensetzung, umfassend einen LaNiO₃-Vorläufer, ein organisches Lösungsmittel und einen Stabilisator, wobei
das Mischungsverhältnis des LaNiO₃-Vorläufers bezogen auf insgesamt 100 Masse-% des LaNiO₃-Vorläufers, des organischen Lösungsmittels und des Stabilisators 1 bis 20 Masse-% auf einer Oxidbasis beträgt, das Mischungsverhältnis des Stabilisators bezogen auf eine Gesamtmenge des LaNiO₃-Vodäufers (1 Mol) mehr als 0 Mol und 10 Mol oder weniger beträgt und der Rest das organische Lösungsmittel ist,
**dadurch gekennzeichnet, dass**
das organische Lösungsmittel eine Art eines einzelnes Lösungsmittel ist, das ausgewählt ist aus der Gruppe bestehend aus Ethylenglykolmonopropylether, Ethylenglykolmonoisopropylether, 3-Methoxy-1-butanol, Hexamethylentetramin, Isoamylacetat, Glycerin-1,2-carbonat, Diethylcarbonat, und Milchsäure oder ein gemischtes Lösungsmittel, bestehend aus Ethylenglykolmonoisopropylether und Ethanol, und
die Dispersionskomponente dD, die Polarisationskomponente dP und die Wasserstoffbindungskomponente dH des HSP-Wertes des organischen Lösungsmittels jeweils die Beziehungen 14<dD<20, 3<dP<26 und 3<dH<30 erfüllen.

2. LaNiO₃-Dünnschicht bildende Zusammensetzung nach Anspruch 1, wobei der LaNiO₃-Vorläufer Metallcarboxylat, Metallnitrat, Metallalkoxid, ein Metalldiolkomplex, ein Metalltriolkomplex, ein Metall-β-Diketonatkomplex, ein Metall-β-Diketoesterkomplex, ein Metall-β-Iminoketokomplex oder ein Metallaminokomplex ist.

3. LaNiO₃-Dünnschicht bildende Zusammensetzung nach Anspruch 2, wobei mindestens einer von einem LaNiO₃-Vorläufer als eine La-Quelle und einem LaNiO₃-Vorläufer als eine Ni-Quelle unter den LaNiO₃-Vorläufern Acetat ist.

4. LaNiO₃-Dünnschicht bildende Zusammensetzung nach Anspruch 2, wobei mindestens einer von einem LaNiO₃-Vorläufer als eine La-Quelle und einem LaNO₃-Vorläufer als eine Ni-Quelle unter den LaNiO₃-Vorläufern Nitrat ist.

5. Verfahren zum Bilden einer LaNiO₃-Dünnschicht, bei dem die LaNiO₃-Dünnschicht bildende Zusammensetzung nach einem der Ansprüche 1 bis 4 verwendet wird.

6. Verfahren zum Bilden einer LaNiO₃-Dünnschicht nach Anspruch 5, umfassend die Schritte von:
Bilden einer Beschichtungsschicht durch Aufbringen der LaNiO₃-Dünnschicht bildenden Zusammensetzung nach einem der Ansprüche 1 bis 4 auf ein wärmebeständiges Substrat; und
nach dem Kalzinieren des Substrats mit der Beschichtungsschicht bei Atmosphärendruck in oxidierender Atmosphäre oder in wasserdampfhaltiger Atmosphäre oder zweimalig oder mehr wiederholtem Bilden und Kalzinieren der Beschichtungsschicht, bis die Dicke einen gewünschten Wert erreicht, und Bilden einer LaNiO₃-Dünnschicht, die vorzugsweise auf eine (100)-Ebene auf dem Substrat ausgerichtet ist, durch Brennen der Beschichtungsschicht bei einer Kristallisationstemperatur oder mehr.

7. Elektronisches Bauteil enthaltend eine durch das Verfahren nach Anspruch 5 oder 6 gebildete LaNiO₃-Dünnschicht.

## Revendications

1. Composition de formation de film mince de LaNiO₃, comprenant un précurseur de LaNiO₃, un solvant organique et un stabilisant, dans lequel
le rapport de mélange du précurseur de LaNiO₃ par rapport à un total de 100 % en masse du précurseur de LaNiO₃, du solvant organique, et du stabilisant est de 1 à 20 % en masse sur la base des oxydes, le rapport de mélange du stabilisant par rapport à une quantité totale du précurseur de LaNiO₃ (1 mole) est supérieur à 0 mole et inférieur ou égal à 10 moles, et le reste est le solvant organique,
**caractérisée en ce que**,
le solvant organique est un type de solvant organique sélectionné parmi le groupe constitué de l'éther monopropylique de l'éthylène glycol, de l'éther monoisopropylique de l'éthylène glycol, du 3-méthoxy-1-butanol, de l'hexaméthylène tétramine, de l'acétate d'isoamyle, du 1,2-carbonate de glycérol, du carbonate de diéthyle, et de l'acide lactique ou un solvant mixte composé d'éther monoisopropylique de l'éthylène glycol et d'éthanol, et
la composante de dispersion dD, la composante de polarisation dP, et la composante de liaison hydrogène dH de la valeur HSP du solvant organique satisfont les relations 14<dD<20, 3<dP<26, et 3<dH<30, respectivement.

2. Composition de formation de film mince de LaNiO₃ selon la revendication 1, dans laquelle le précurseur de LaNiO₃ est un carboxylate métallique, un nitrate métallique, un alcoxyde métallique, un complexe métal-diol, un complexe métal-triol, un complexe métal-β-dicétonate, un complexe métal-β-dicétoester, un complexe métal-β-iminocéto, ou un complexe métal-amino.

3. Composition de formation de film mince de LaNiO₃ selon la revendication 2, dans laquelle au moins l'un d'un précurseur de LaNiO₃ tel qu'une source de La et d'un précurseur de LaNiO₃ tel qu'une source de Ni parmi les précurseurs de LaNiO₃ est l'acétate.

4. Composition de formation de film mince de LaNiO₃ selon la revendication 2, dans laquelle au moins l'un d'un précurseur de LaNiO₃ tel qu'une source de La et d'un précurseur de LaNiO₃ tel qu'une source de Ni parmi les précurseurs de LaNiO₃ est le nitrate.

5. Procédé pour former un film mince de LaNiO₃ dans lequel la composition de formation de film mince de LaNiO₃ selon l'une quelconque des revendications 1 à 4 est utilisée.

6. Procédé pour former un film mince de LaNiO₃ selon la revendication 5, comprenant les étapes de :
formation d'un film de revêtement en appliquant la composition de formation de film mince de LaNiO₃ selon l'une quelconque des revendications 1 à 4 sur un substrat thermorésistant ; et
après la calcination du substrat, le placement du film de revêtement sous pression atmosphérique dans une atmosphère oxydante ou dans une atmosphère contenant de la vapeur d'eau ou la formation et la calcination répétées du film de revêtement au moins deux fois jusqu'à ce que l'épaisseur atteigne une valeur souhaitée, et la formation d'un film mince de LaNiO₃ orienté préférentiellement vers un plan (100) sur le substrat par cuisson du film de revêtement à une température supérieure ou égale à la température de cristallisation.

7. Composant électronique incluant un film mince de LaNiO₃ formé par le procédé selon la revendication 5 ou 6.
